Europäisches Patentamt

European Patent Office

Office européen des brevets

(11) Publication number: **0 141 495**

**B1**

(12) **EUROPEAN PATENT SPECIFICATION**

(45) Date of publication of patent specification: 26.04.89

(51) Int. Cl.⁴: **C 30 B 15/14**

(21) Application number: 84305619.3

(22) Date of filing: 17.08.84

(54) **A method for pulling a single crystal.**

(30) Priority: 23.08.83 JP 154264/83

(43) Date of publication of application:
15.05.85 Bulletin 85/20

(45) Publication of the grant of the patent:
26.04.89 Bulletin 89/17

(84) Designated Contracting States:
DE FR GB

(56) References cited:
EP-A-0 104 559
FR-A-1 435 250

PATENTS ABSTRACTS OF JAPAN, vol. 7, no.
247(E-208)(1392), 2nd November 1983;

PATENTS ABSTRACTS OF JAPAN, vol. 6, no.
73(C-101)(951), 8th May 1982;

(73) Proprietor: SUMITOMO ELECTRIC INDUSTRIES
LIMITED
No. 15, Kitahama 5-chome Higashi-ku
Osaka-shi Osaka 541 (JP)
(73) Proprietor: NIPPON TELEGRAPH AND
TELEPHONE CORPORATION
1-6 Uchisaiwaicho 1-chome Chiyoda-ku
Tokyo (JP)

(72) Inventor: Kawasaki, Akihisa Osaka Works of
Sumitomo
Electric Industries, Ltd., 1-3, Shimaya 1-chome
Konohana-ku Osaka-shi Osaka (JP)
Inventor: Kotani, Tochihiro Osaka Works of
Sumitomo
Electric Industries, Ltd., 1-3, Shimaya 1-chome
Konohana-ku Osaka-shi Osaka (JP)
Inventor: Nakai, Ryusuke Osaka Works of
Sumitomo
Electric Industries, Ltd., 1-3, Shimaya 1-chome
Konohana-ku Osaka-shi Osaka (JP)
Inventor: Miyazawa, Shintaro
No. 7-504, 861-1, Ishida
Isehara-shi Kanagawa (JP)
Inventor: Hoshikawa, Keigo
No. 4-104, 861-1, Ishida
Isehara-shi Kanagawa (JP)

Courier Press, Leamington Spa, England.

# EP 0 141 495 B1

(74) Representative: **Cross, Rupert Edward Blount et al**
**BOULT, WADE & TENNANT 27 Furnival Street London EC4A 1PQ (GB)**

## Description

### Background of the invention
### 1. Field of the invention

This invention relates to a method for pulling a single crystal by the Czochralski method (hereinafter referred to as CZ method) or by the Liquid Encapsulated Czochralski method (hereinafter referred to as LEC method).

### 2. Description of prior art

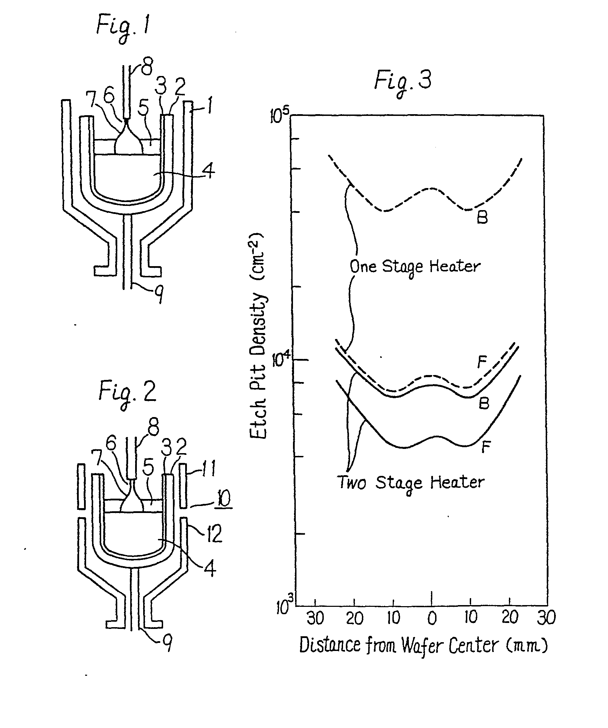

In an apparatus for pulling a single crystal by CZ method or LEC method as shown in Figure 1, raw material melt 4 (e.g. GaAs) is charged in crucible 3, the surface of the melt is optionally covered with $B_2O_3$ melt 5 (in the case of LEC method), and a seed crystal 6 fitted to a pull rod 8 is immersed in the surface of the melt 4, wetted and is then pulled up to obtain a single crystal 7 (e.g. GaAs). 1 is a heater in a furnace, 2 is a susceptor (e.g. carbon) and 9 is a crucible support shaft.

In this case, one heater has been used so as to maintain a predetermined temperature distribution in the furnace. It has now been appreciated that a single heater is inadequate because of the following reasons. The temperature distribution on the (vertical) central axis of the single crystal 7 varies with time when seeding, when single crystal 7 comes out of $B_2O_3$ melt and when the major part of single crystal 7 is pulled, and for example, the dislocation density (EPD) is thus substantially increased from the seed end to the tail end. As the single crystal 7 is pulled out of the $B_2O_3$ melt 5, for example, the single crystal 7 is cooled by a high pressure gas and the temperature gradient in the axial direction of single crystal 7 increases, causing thermal stress and increasing the dislocation density. A large temperature gradient in $B_2O_3$ melt 5 is also a cause thereof.

Thus it has now been appreciated that by using one heater, it is impossible to controllably heat the single crystal 7 and the raw material melt 4 independently and to hold constant the temperature distribution in the vicinity of the solid-liquid interface from the start to the end of pulling. Accordingly, the single crystal cannot be held in a low dislocation density from the seed end to the tail end thereof by the use of one heater as in the prior art.

### Summary of the invention

It is an object of the present invention to provide a method for the growth of single crystals, whereby the above-described disadvantages of the prior art can be overcome.

It is another object of the present invention to provide a method for the Czochralski growth of compound single crystals in which the temperature distribution in the vertical direction can readily be controlled from seeding to pulling-up of a single crystal.

It is a further object of the present invention to provide a method for pulling a single crystal with a low dislocation density.

It is known from JP—A—58-135626 to provide two heaters, divided in the vicinity of the solid-liquid interface, in a method of pulling a crystal by the fully-encapsulated pulling method. In the described method the upper heater is controlled to maintain the encapsulating liquid at a fixed temperature.

EP—A—0104559 which is prior art according to Article 54(3) of the European Patent Convention, discloses the pulling of a single crystal by a Czochralski method in which the pulled crystal is not encapsulated or is not fully encapsulated employing an apparatus which comprises a crucible holding raw material for the crystal, means for pulling raw material from the crucible into the single crystal, a lower heater disposed around the outside of a lower part of the crucible and an upper heater which extends only around an upper portion of the crucible, the division between the heaters being in the vicinity of the solid-liquid interface of the material which is drawn up from the crucible. Such a method is characterised according to the invention in that the lower heater extends underneath the crucible and in that heaters are controlled to maintain a vertical temperature gradient between 5 and 100°C/cm at least in the vicinity of the said interface.

### Brief description of the drawings

The accompanying drawings are to illustrate the principle and merits of the present invention in more detail.

Figure 1 is a vertical-sectional view of one example of an apparatus for pulling a single crystal according to the prior art.

Figure 2 is a vertical-sectional view of one embodiment of an apparatus for pulling a single crystal according to the method of the present invention.

Figure 3 is a graph showing the etch pit density distributions on the seed ends and the tail ends of single crystals prepared according to the present invention and the prior art.

### Detailed description of the invention

The inventors have made various efforts to develop an apparatus for the Czochralski growth of a single crystal with a lowered dislocation density from the seed end to the tail end of the single crystal and consequently have found that such a single crystal can be obtained by the use of a single crystal pulling apparatus provided with two or more heaters (two or more heating zones) divided at least in the vicinity of the solid-liquid interface, whereby the temperature distribution in the vertical direction can readily be controlled. The present invention is based on this finding.

Accordingly, the present invention provides a method for pulling a single crystal by CZ method, wherein a heater in a furnace consists of two or more heaters or heating zones divided in the vicinity of the solid-liquid interface. The divided two or more heaters serve to control the temperature gradient in the vertical direction near the solid-liquid interface to be 5—100°C/cm, preferably 5 to 60°C/cm more prererably 5 to 30°C/cm.

Single crystals which can be pulled by the method of the present invention include compounds of Group III—V elements of Periodic Table (e.g. GaAs, InAs, GaP, InP, etc.), compounds of Group II—VI elements (e.g. ZnSe, etc.) or their mixed crystals, elementary semiconductors such as Si and Ge, oxides, nitrides, carbides and the like. In particular, the method of the present invention can be usefully applied to the LEC method in which control of temperature gradient in the vertical direction is difficult because of the necessity of pulling a single crystal under a high pressure, e.g. 10 to 60 bar (10 to 60 atm) using $B_2O_3$ melt.

The present invention will now be illustrated as to one preferred embodiment referring to the accompanying drawing. Figure 2 is a vertically sectional view of one example of the apparatus employed in the method of the present invention, in which the same numerals show the same parts as those of Figure 1. The difference between Figure 1 and Figure 2 is that heater 1 in a furnace of Figure 1 is divided in the vicinity of the interface between raw material melt 4 and $B_2O_3$ melt 5 (solid-liquid interface) into a multi-stage heater 10 consisting of at least an upper heater 11 and a lower heater 12. Upper heater 11 is mainly used for the purpose of controlling the temperature in the vicinity of the solid-liquid interface and that of the pulled single crystal, and the lower heater 12 is used for the purpose of mainly controlling the temperature of the raw material melt. These heaters are controlled individually or in combination, whereby the temperature in the vertical direction can readily be controlled to give a predetermined temperature distribution from seeding of a single crystal to the end of pulling the same.

One preferred embodiment of pulling a single crystal by the method of the present invention will be given below:

Firstly, the (calorific) power ratio of heaters 11 and 12 is adjusted to provide conditions capable of giving a temperature gradient between 5 and 100°C/cm in the central portion of the $B_2O_3$ melt 5 in the vertical direction. Under these conditions, seeding is started and when single crystal 7 comes out of the $B_2O_3$ melt 5 and is exposed to a high pressure gas, the single crystal 7 is warmed by upper heater 11 while the growth of the diameter of single crystal 7 is monitored, and pulling of the single crystal is continued while the temperature gradient in the vertical direction near the solid-liquid interface is maintained between 5 to 100°C/cm.

When the power of upper heater 11 is increased and single crystal 7 becomes smaller, the power of lower heater 12 is somewhat decreased and pulling is continued to keep the diameter of single crystal 7. The power ratio as described above depends largely on the heater structure, but, for example, is in the range of an upper to lower ratio of 1—2 to obtain a temperature gradient of 5—60°C/cm.

Since the heater for heating the inside of a furnace is divided in two stages 11 and 12 which can be controlled individually or conjointly as described above, control of the temperature distribution during growth of a single crystal can readily be carried out to maintain constant the diameter of the single crystal.

The heater for heating the inside of a furnace in the present invention is not limited to that of two stages or zones as shown in Figure 2, but other heaters of three or more stages or zones can of course be used if at least one divided part thereof is provided in the vicinity of the solid-liquid interface.

The method for pulling a single crystal according to the present invention, as illustrated above, has the following advantages:

Since the heater for heating the inside of a furnace is constructed of heaters of two or more stages, divided at least in the vicinity of the crystal growth interface, it is possible to control these heaters individually, to change freely the temperature gradient in the vertical direction near the solid-liquid interface of a single crystal, to decrease the temperature gradient, in particular, when the single crystal comes out of $B_2O_3$ melt, and to keep small and constant the temperature gradient from the start to the end of pulling the single crystal. Therefore, the method of the present invention results in production of a high quality single crystal with a low dislocation density and a uniformity of dislocation densities from the seed end to the tail end of the single crystal in a high yield.

For example, LED fabricated on wafer with a large dislocation density has a short life, semiinsulating single crystal of GaAs (undoped or Cr-doped) has a strong relationship between the dislocation density and resistance and the yield of a device is greatly affected by the dislocation density, so the method of the present invention has important significances, in particular, in these uses.

The following example is given in order to illustrate the present invention without limiting the same.

Example

GaAs single crystal was pulled using the apparatus as shown in Figure 2.

About 5 kg of GaAs polycrystal raw material and 500 g of $B_2O_3$ were charged in a quartz crucible of 150 mm in diameter, melted and pulled in a <001> direction at a pressure of 10 bar (10 kg/cm$^2$) in a furnace, a pulling rate of 12 mm/hr, a crucible raising rate of 1 mm/hr, a pull rod 8 and crucible support rod 9 revolving rate of 10 rpm and a temperature gradient of about 20°C/cm, the temperature gradient being in the vertical direction near the solid-liquid interface during seeding, thus obtaining GaAs single crystal of 50 mm in diameter and about 500 mm in length. During the growing, the temperature gradient was held at 20°C/cm.

For comparison, a single crystal was similarly prepared but using a pulling apparatus of the prior art, provided with only one heater. In this case, the temperature gradient was above 100°C/cm.

(001) wafers cut from the seed end (F) and the tail end (B) of the single crytals were subjected to etching with molten KOH and to measurement of the etch pit density (EPD), thus obtaining results as shown in Figure 3, in which solid lines showed EPD when using the two-stage heater and dotted lines showed EPD when using the one-stage heater, ordinate: EPD ($cm^{-2}$) and abscissa: distance (mm) from centre of water. EPD was measured at points in <011> direction on (001) wafers. The mean EPD was as shown in Table 1:

TABLE 1
Mean EPD ($\times 10^4$ $cm^{-2}$)

|  | Seed end (F) | Tail end (B) |
|---|---|---|
| Present invention | 0.6 | 0.9 |
| Prior art | 0.9 | 5 |

As is evident from the results of Figure 3 and Table 1, EPD is lower and is scarcely changed from the seed end to the tail end in the present invention, while EPD is remarkably increased from the seed end to the tail end in the prior art.

**Claim**

A method of pulling a single crystal by a Czochralski method in which the pulled crystal is not encapsulated or is not fully encapsulated, employing an apparatus which comprises a crucible holding raw material for the crystal, means for pulling raw material from the crucible into the single crystal, a lower heater disposed around the outside of a lower part of the crucible and an upper heater which extends only around an upper portion of the crucible, the division between the heaters being in the vicinity of the solid-liquid interface of the material which is drawn up from the crucible, characterised in that the lower heater extends underneath the crucible and in that the heaters are controlled to maintain a vertical temperature gradient between 5 and 100°C/cm at least in the vicinity of the said interface.

**Patentanspruch**

Verfahren zum Ziehen eines Einkristalls nach einem Czochralski-Verfahren, bei welchem der gezogene Kristall nicht eingekapselt oder nicht voll eingekapselt ist und eine Vorrichtung verwendet wird, die einen Rohmaterial für den Kristall haltenden Tiegel, Einrichtungen zum Ziehen des Rohmaterials aus dem Tiegel zu dem Einkristall, eine um die Außenseite eines unteren Teils des Tiegels herum angeordnete untere Beheizung und eine obere Beheizung aufweist, die sich nur um einen oberen Abschnitt des Tiegels erstreckt, wobei die Unterteilung zwischen den Beheizungen in der Nähe der Fest-Flüssig-Trennfläche des Materials liegt, das aus dem Tiegel hochgezogen wird, dadurch gekennzeichnet, daß die untere Beheizung sich unter den Tiegel erstreckt und daß die Beheizungen so gesteuert werden, daß ein vertikaler Temperaturgradient zwischen 5 und 100°C/cm wenigstens in der Nähe der genannten Trennfläche aufrechterhalten wird.

**Revendication**

Procédé pour le tirage d'un monocristal par la méthode de Czochralski, dans lequel le cristal tiré n'est pas encapsulé ou n'est pas entièrement encapsulé, utilisant un appareillage qui comprend un creuset destiné à contenir la matière première du cristal, un moyen pour tirer la matière première du creuset et la transformer en le monocristal, un élément chauffant inférieur disposé autour de l'extérieur d'une partie inférieure de creuset, et un élément chauffant supérieur qui ne s'étend qu'autour d'une partie supérieure du creuset, la séparation entre les élément chauffants se trouvant au voisinage de l'interface solide-liquide du mátériau tiré du creuset, caractérisé en ce que l'élément chauffant inférieur s'étend en-dessous du creuset, et que les éléments chauffants sont régulés de façon à maintenir au moins au voisinage de ladite interface un gradient vertical de température compris entre 5 et 100°C/cm.

Fig. 1

Fig. 2

Fig. 3

Etch Pit Density (cm$^{-2}$)

One Stage Heater

Two Stage Heater

Distance from Wafer Center (mm)